# EUROPEAN PATENT APPLICATION

(11) **EP 1 959 491 A2**
(43) Date of publication of application: **20.08.2008**
(21) Application number: 07113787.1
(22) Date of filing: 03.08.2007
(51) Int. Cl.: H01L 21/8234, H01L 21/8238, H01L 27/088, H01L 27/092

(54) **Semiconductor device and method for manufacturing the same**

(30) Priority: 16.02.2007 JP 2007036440
(71) Applicant: MATSUSHITA ELECTRIC INDUSTRIAL CO., LTD., Kadoma-shi, Osaka 571-8501 (JP); INTERUNIVERSITAIR MICRO-ELEKTRONICA CENTRUM VZW, 3001 Leuven Brabant (BE)
(72) Inventor: Mitsuhashi, Riichiro, Osaka-shi Osaka 540-6207 (JP); Singanamalla, Raghunath, 3001 Heverlee (BE)
(74) Representative: Grünecker, Kinkeldey, Stockmair & Schwanhäusser Anwaltssozietät

(57) **Abstract**

A semiconductor device includes a p-type active region and an n-type active region which are formed in a semiconductor substrate and a p-type MISFET including a gate insulating film (1006) formed on the p-type active region and a first gate electrode including a first electrode formation film (1015) of which upper part has a concentration of La higher than the other part thereof. The semiconductor device further includes an n-type MISFET including a gate insulating film (1006) formed on the n-type active region and a second gate electrode including a second electrode formation film (1014) of which upper part has a concentration of A1 higher than the other part thereof.

## Description

### Background of the Invention

### Field of the Invention

The present invention relates to semiconductor devices and manufacturing methods thereof.

### Background Art

In recent years, semiconductor devices are being required to operate at high speed with low power consumption. In order to achieve high speed operation of the semiconductor devices, the gate capacitance of MISFETs (Metal Insulator Semiconductor Field Effect Transistors) is increased to increase the driving current. In order to increase the gate capacitance, the distance between electrodes (between a substrate and an electrode) must be reduced by reducing the thickness of the gate insulating films. In response to this demand, the physical thickness of the gate insulating films of the MISFETs are reduced now to approximately 2 nm in a case using SiON (silicon oxinitride). While, recent reduction in thickness of the gate insulating films involves a problem of gate leak current. In order to cope with this problem, the use of materials having high dielectric constants, such as an oxide containing Hf is being examined in place of the conventionally used silicon oxide (SiO₂) based materials.

Reduction in thickness of the gate insulating films involves another problem that the gate electrodes that have been made of polysilicon are depleted to lower the gate capacitance. In terms of a film thickness of a gate insulating film made of, for example, silicon oxide (SiO₂), the lowered amount of the gate capacitance in this case increases the film thickness by approximately 0.5 nm. The thinned gate insulating films inevitably involve an increase in gate leak current, but nevertheless reduction in effective thickness of the gate insulating films can be achieved without increasing the gate leak current if depletion can be suppressed. When the thickness of a SiO₂ film is reduced by 0.1 nm, leak current increases ten times or more than that before reduction in thickness. Thus, suppression of depletion of the gate electrodes is significantly effective.

In view of the foregoing, exchange of the material of the gate electrodes from polysilicon to metal causing no depletion is being examined for obviating depletion of the gate electrodes. Nevertheless, while formation of the impurity level by implantation of impurity into polysilicon enables separate formation of a p-MISFET electrode and an n-MISFET electrode, such separate formation is disabled with the metal. Besides, recent semiconductor devices are required to operate at further higher speed. Therefore, lowering of threshold voltage (Vt) is an essential issue, and the p-MISFET electrode and the n-MISFET electrode should have work functions (WF) approximating to the band edge of silicon. Wherein, the band edge means a high WF approximating to the work function (approximately 5.2 eV) at the upper part (top edge) of the valence band of silicon in the p-side region and a low WF approximating to the work function (approximately 4.1 eV) at the bottom part (bottom edge) of the conduction band of silicon in the n-side region. The conventional semiconductor devices are so designed that the p-MISFET and the n-MISFET thereof have the same threshold voltage Vt by using metal having a WF corresponding to the substantial mean value between the WF in the p-side region and that in the n-side region as a common material of the p-MISFET electrode and the n-MISFET electrode. Such semiconductor devices will become impractical any longer.

Under the circumstances, for using metal as a material of the gate electrodes, the material and the compositions thereof should be changed between the p-MISFET and the n-MISFET. In the case where the material and the compositions of the gate electrodes are different between the p-MISFET and the n-MISFET, formation of the p-MISFET and the n-MIFSET on a single semiconductor substrate, for example, formation of a CMIS (Complementary Metal Insulator Semiconductor) requires a process of, for example: depositing metal for the n-MISFET (or the p-MISFET) on a gate insulating film; selectively removing a part of the metal for the n-MISFET (or the p-MISFET) which is formed in the p-MISFET region (or the n-MISFET region); and then, depositing meal for the p-MISFET (or the n-MISFET) on a part of the gate insulating film which is formed in the p-MISFET region (or the n-MISFET region) (see F. Ootsuka et al., "Extended Abstract of the 2006 International Conference on Solid State Device and Materials," Yokohama, 2006, pp. 1116-1117).

### Summary of the Invention

When the aforementioned method is employed, however, metal immediately on the gate insulating film must be removed, thereby inviting change in film thickness of the gate insulating film and lowering of reliability. Though several other processes for separately forming the p-MISFET and the n-MISFET may be contemplated, removal of a film formed on the gate insulating film might inevitably invite damage to the thinned gate insulating film.

Referring to a method of forming gate electrodes different between in the p-side region and in the n-side region, in forming fully silicided gate electrodes, a method is employed in which the level of the polysilicon film formed in the p-side region is set low by etching and the composition of silicon in the p-side region is set different from that in the n-side region (see J. A. Kittl et al., "VLSI Technology," 2005, p. 72, for example). In the method in which the phases of the material composing the gate electrodes are changed, however, it is difficult to provide respective optimal work functions to the p-side region and the n-side region with the use of silicide containing the same element.

A method avoiding removal of a film on the gate insulating film by ion implantation or the like may be contemplated. In the case where the gate electrodes are made of metal, however, the impurity level cannot be formed unlike semiconductor materials and a considerably large dosage is required, thereby inviting damage to the gate insulating film.

The above problem is involved not only in the case using metal-made gate electrodes but also in the case where a plurality of MISFETs including gate electrodes made of different materials are formed in a plurality of regions in a single substrate.

In view of the foregoing, the present invention has its object of providing a semiconductor device including a gate insulating film excellent in quality even when miniaturized, having high reliability, and capable of high-speed operation and a manufacturing method thereof.

To attain the above object, a semiconductor device in accordance with the present invention includes: a semiconductor substrate; first and second regions formed in the semiconductor substrate; a first MISFET including a first gate insulating film which is formed on the first region and a first gate electrode which is formed on the first gate insulating film and includes a first electrode formation film of which upper part and other part each include a first metallic element or a first conductivity type compound, a concentration of the first metallic element or the first conductivity type compound of the upper part being larger than a concentration of the first metallic element or the first conductivity type compound of the other part; and a second MISFET including a second gate insulating film which is formed on the second region and a second gate electrode which is formed on the second gate insulating film and includes a second electrode formation film of which upper part and other part each include a second metallic element or a second conductivity type compound, a concentration of the second metallic element or the second conductivity type compound of the upper part being larger than a concentration of the second metallic element or the second conductivity type compound of the other part. Wherein, the first region may be a p-type active region while the second region may be an n-type active region. In this case, preferably, the first metallic element has a work function smaller than the second metallic element.

In the above arrangement, the first MISFET and the second MISFET different in material of the gate electrodes are formed in the single semiconductor substrate. If the first region is the p-type active region while the second region is the n-type active region and the first gate electrode of the n-type MISFET contains the first metallic element or the first conductivity type compound having a low work function while the second gate electrode of the p-type MISFET contains the second metallic element or the second conductivity type compound having a high work function, the n-type MISFET and the p-type MISFET of the semiconductor device have low threshold voltage and are capable of high-speed operation even when miniaturized. Preferably, at least one of the first electrode formation film and the second electrode formation film is formed of an alloy film.

A method for manufacturing a semiconductor device in accordance with the present invention is a method for manufacturing a semiconductor device including a semiconductor substrate, first and second regions, a first MISFET including a first gate insulating film and a first gate electrode, and a second MISFET including a second gate insulating film and a second gate electrode, which includes the steps of: (a) after formation of the first region and the second region in the semiconductor substrate, forming the first gate insulating film on the first region and forming the second gate insulating film on the second region; (b) forming a protection film on the first gate insulating film and the second gate insulating film; (c) forming a first electrode formation film on a part of the protection film which is formed on the first gate insulating film; (d) forming a second electrode formation film on a part of the protection film which is formed on the second gate insulating film; and (e) heating the semiconductor substrate to cause a reaction of the protection film to the first electrode formation film for forming the first gate electrode that includes a third electrode formation film and to cause a reaction of the protection film to the second electrode formation film for forming the second gate electrode that includes a fourth electrode formation film.

In the above method, the protection film for protecting the first gate insulating film and the second gate insulating film is provided in the step (b) to prevent damage by etching and the like to the first gate insulating film and the second insulating film in forming the first electrode formation film and the second electrode formation film in the step (c) and the step (d). Hence, employment of the semiconductor device manufacturing method in accordance with the present invention attains a highly reliable semiconductor device including the gate insulting films excellent in quality even when miniaturized. Further, the thermal treatment performed to cause reactions of the protection film with the first electrode formation film and the second electrode formation film in the step (e) leads to formation of the third electrode formation film and the fourth electrode formation film having different compositions on the single semiconductor substrate. This achieves comparatively easy separate formation of the first MISFET and the second MISFET including the gate electrodes made of different materials on the single semiconductor substrate. Preferably, at least one of the third electrode formation film and the fourth electrode formation film is formed of an alloy film.

The first region may be a p-type active region while the second region may be an n-type active region. Preferably, the first electrode formation film contains at least one of HfN, HfC, TaC, and a material including a lanthanoide-based element. Further, it is preferable that the second electrode formation film contains at least one of TaCN, TaCNO, and a material containing at least one of noble metal, Al, Mo, and W.

With the above arrangement, the n-type MISFET and the p-type MISFET including the gate electrodes containing the metals can be formed in the single semiconductor substrate to suppress depletion of the gate electrodes even when miniaturized, thereby attaining a semiconductor device capable of high-speed operation.

In the above semiconductor device manufacturing method, the first gate insulating film and the second gate insulating film may be formed of the same material, and in the step (a), the first gate insulating film and the second gate insulating film may be formed simultaneously. This method simplifies the steps.

It is preferable that the first gate insulating film and the second gate insulating film are made of high dielectrics. This suppresses leak current even with a thinned gate insulating film to attain a semiconductor device having high current drivability.

The semiconductor device manufacturing method may further includes the step of: (f) forming a fifth electrode formation film on or above the first electrode formation film and forming a sixth electrode formation film on or above the second electrode formation film, and the first gate electrode may further include the fifth electrode formation film while the second gate electrode may further include the sixth electrode formation film in the step (e). Further, it is preferable that at least one of the fifth electrode formation film and the sixth electrode formation film contains metal.

The above arrangement contemplates lowered resistances of the first gate electrode and the second gate electrode, enabling manufacture of a semiconductor device operating at further higher speed.

Furthermore, in the step (f), a first intermediate film may be formed in addition between the first electrode formation film and the fifth electrode formation film while a second intermediate film may be formed in addition between the second electrode formation film and the sixth electrode formation film, and in the step (e), the first gate electrode further may include the first intermediate film while the second gate electrode further includes the second intermediate film.

In this aspect, in the case, for example, where materials liable to be oxidized are used as the material of the first electrode formation film and the second electrode formation film, formation of the first intermediate film and the second intermediate film made of a material having an anti-oxidizing function prevents degeneration by oxidation of the first electrode formation film and the second electrode formation film. Hence, lowering of the quality of the gate electrodes can be suppressed to attain a highly reliable semiconductor device.

### Brief Description of the Drawings

FIG. **1** is a graph showing dependency of work functions on the thickness of a TiN film in the present invention.
FIG. **2A** to FIG.**2E** are sectional views showing a semiconductor manufacturing method in accordance with Embodiment 1 of the present invention.
FIG. **3A** to FIG. **3E** are sectional views showing the semiconductor manufacturing method in accordance with Embodiment 1 of the present invention.
FIG. **4A** to FIG. **4E** are sectional views showing the semiconductor manufacturing method in accordance with Embodiment 1 of the present invention.
FIG. **5A** to FIG. **5D** are sectional views showing the semiconductor manufacturing method in accordance with Embodiment 1 of the present invention.
FIG. **6A** and FIG. **6B** are sectional views showing the semiconductor manufacturing method in accordance with Embodiment 1 of the present invention.
FIG. **7A** to FIG. **7E** are sectional views showing a semiconductor manufacturing method in accordance with Embodiment 2 of the present invention.
FIG. **8A** to FIG. **8E** are sectional views showing the semiconductor manufacturing method in accordance with Embodiment 2 of the present invention.
FIG. **9A** to FIG. **9E** are sectional views showing the semiconductor manufacturing method in accordance with Embodiment 2 of the present invention.
FIG. **10A** and FIG. **10B** are sectional views showing the semiconductor manufacturing method in accordance with Embodiment 2 of the present invention.

### Description of the Preferred Embodiments

### (Embodiment 1)

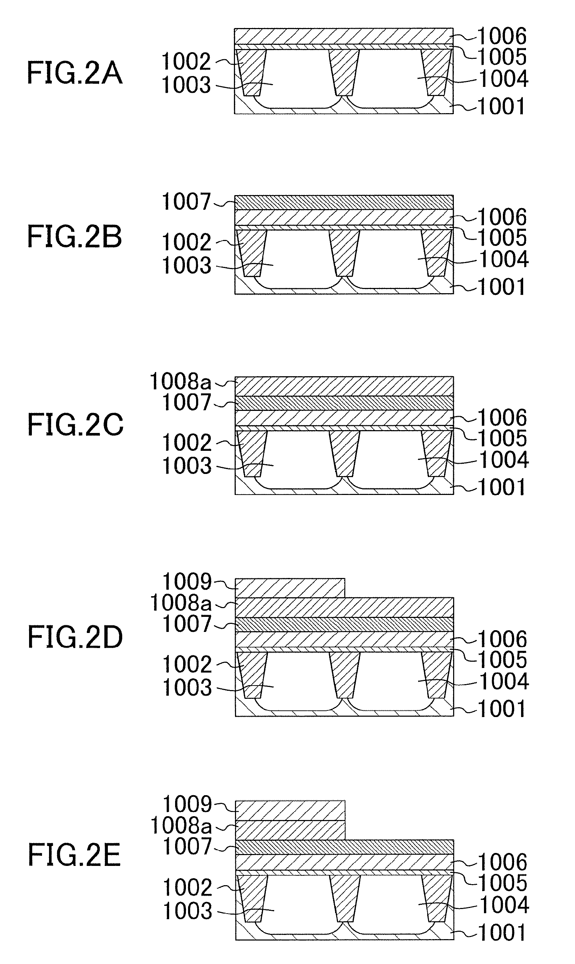

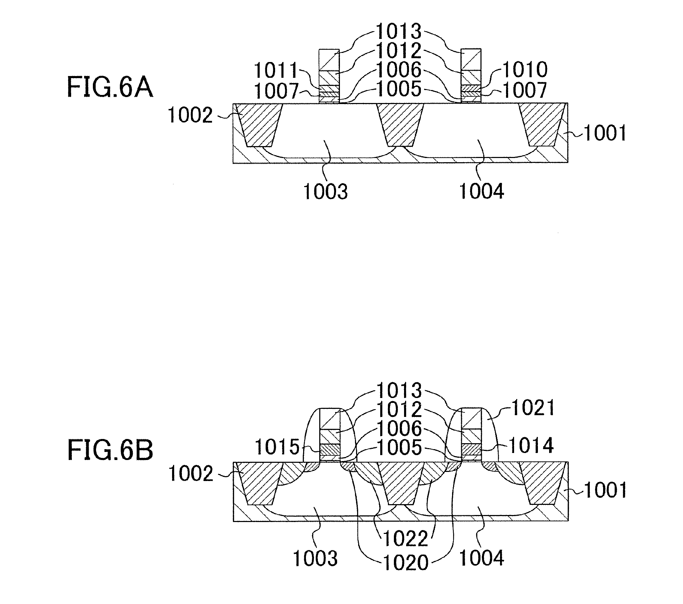

A semiconductor device and a manufacturing method thereof in accordance with Embodiment 1 will be described below with reference to the drawings. FIG. 2 to FIG. 6 are sectional views showing the semiconductor device manufacturing method in accordance with Embodiment 1 of the present invention. First, description will be given with reference to FIG. **6B** to a structure of the semiconductor device in accordance with the present embodiment.

As shown in FIG. **6B**, the semiconductor device in accordance with the present embodiment includes a semiconductor substrate made of, for example, silicon, a p-type active region **1003** and an n-type active region **1004** which are formed in the semiconductor substrate **1001,** and an isolation layer **1002** for separating the p-type active region **1003** and the n-type active region **1004.** It further includes source/drain regions **1022** and extension regions **1020** formed in the p-type active region **1003** and the n-type active region **1004.**

An underlying film **1005** made of SiO₂ or the like is formed on a region of the semiconductor substrate **1001** which is located between two adjacent extension regions **1020** formed in the p-type active region **1003** when viewed in plan; a gate insulating film **1006** made of HfSiON or the like is formed on the underlying film **1005;** a first electrode formation film **1015** made of TaLaN or is like and formed on the gate insulating film **1006;** an intermediate film **1012** made of TaN or the like is formed on the first electrode formation film **1015;** and a third electrode formation film **1013** made of polysilicon or the like is formed on the intermediate film **1012.** Accordingly, an n-type MISFET including the gate insulating film **1006,** a first gate electrode including the first electrode formation film **1015,** the intermediate film **1012,** and the third electrode formation film **1013,** the source/drain regions **1022,** and the extension regions **1020** is formed in the p-type active region **1003.**

On the other hand, an underlying film **1005** made of SiO₂ or the like is formed on a region of the semiconductor substrate **1001** which is located between two adjacent extension regions **1020** formed in the n-type active region **1004** when viewed in plan; a gate insulating film **1006** made of HfSiON or the like is formed on the underlying film **1005;** a second electrode formation film **1014** made of TaAlN or the like is formed on the gate insulating film **1006;** an intermediate film **1012** made of TaN or the like is formed on the second electrode formation film **1014;** and a third electrode formation film **1013** made of polysilicon or the like is formed on the intermediate film **1012.** Accordingly, a p-type MISFET including the gate insulating film **1006,** a second gate electrode including the second electrode formation film **1014,** the intermediate film **1012,** and the third electrode formation film **1013,** the source/drain regions **1022,** and the extension regions **1020** is formed in the n-type active region **1004.**

Sidewalls **1021** are formed on the side faces of the underlying film **1005,** the gate insulating film **1006,** and the first gate electrode and on the side faces of the underlying film **1005,** the gate insulating film **1006,** and the second gate electrode.

The first electrode formation film **1015** made of TaLaN includes an upper part having a concentration of La higher than the other part thereof. As well, the second electrode formation film **1014** includes an upper part having a concentration of Al higher than the other part thereof.

The most significant feature of the semiconductor device in accordance with the present embodiment lies in that the n-type MISFET and the p-type MISFET formed on the single semiconductor substrate include gate electrodes made of different materials. In the case where the first gate electrode of the n-type MISFET contains La having a low work function while the second gate electrode of the p-type MISFET contains Al having a high work function, as in the semiconductor device of the present embodiment, the semiconductor device includes the n-type MISFET and the p-type MISFET having low threshold voltages and operates at high speed with depletion of the gate electrodes suppressed.

Further, the semiconductor device of the present embodiment includes the third electrode formation film **1013** on each of the first gate electrode and the second gate electrode respectively formed in the n-type MISFET and the p-type MISFET, so that the first gate electrode and the second gate electrode are reduced in resistance.

In the semiconductor device of the present embodiment, the intermediate layers **1012** made of TaN or the like are formed between the first electrode formation film **1015** and the third electrode formation film **1013** and between the second electrode formation film **1014** and the third electrode formation film **1013** to function as anti-oxidation films in the case where the first electrode formation film **1015** is made of a material containing an element liable to be oxidized, such as La.

The semiconductor device manufacturing method in accordance with the present embodiment will be described next with reference to FIG. **2** to FIG. **6****.**

First, as shown in FIG. **2A****,** the p-type active region **1003,** the n-type active region **1004,** and the isolation layer **1002** for separating them are formed in the semiconductor substrate **1001.** RTO (Rapid Thermal Oxidation) using an oxygen gas is performed to deposit the underlying layer **1005** made of, for example, SiO₂ and having a film thickness of approximately 1 nm on the semiconductor substrate **1001.** A gas other than the oxygen gas may be used. The thermal treatment may be performed by using a heating furnace. The material of the underlying film **1005** may be SiON, chemical oxide, or the like. Then, a HFSiO film having, for example, a high dielectric constant and a thickness of 2.5 nm is deposited by MOCVD (Metal Organic Chemical Vapor Deposition), and the thus deposited HfSiO film is plasma-nitrided to form the gate insulating film **1006** formed of the HfSiON film. The gate insulating film **1006** may be made of another material having a high dielectric, such as Al₂O₃, ZrO₂, HfO₂, LaO, DyO, ScO, or the like and, alternatively, may be made of SiO₂ or SiON other than the high dielectrics according to needs. Rather than MOCVD, CVD (Chemical Vapor Deposition), PVD (Physical Vapor Deposition) or the like may be performed.

Next, as shown in FIG. **2B**, a protection film **1007** made of TaN or the like and having a thickness of approximately 2 nm is deposited on the gate insulating film **1006.** The protection film **1007** may be made of TiN, TaC, TaCN, or the like and preferably is made of metal containing Ti or Ta. The film thickness of the protection film **1007,** which can be changed appropriately according to the material thereof and the peripheral process, is preferably 3 nm or smaller.

Subsequently, as shown in FIG. **2C****,** a hard mask **1008a** made of SiO₂ or the like is formed on the protection film **1007.** Then, a resist **1009** is formed on the hard mask **1008a,** and a part of the resist **1009** which is located above the n-type active region **1004** is removed by photolithography, as shown in FIG. **2D****.**

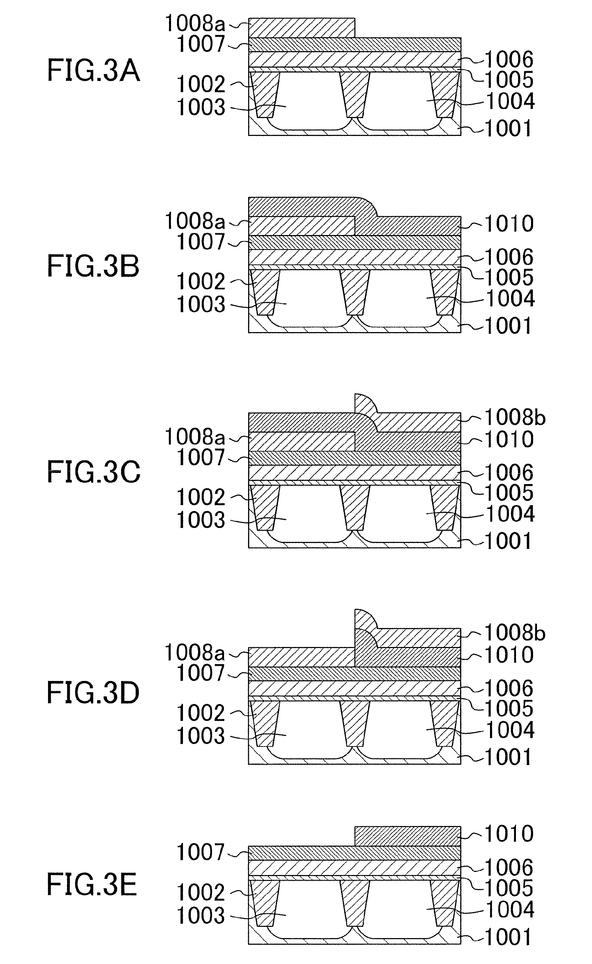

Thereafter, as shown in FIG. **2E****,** etching using the resist **1009** remaining above the p-type active region as a mask is performed to remove a part of the hard mask **1008a** which is located above the n-type active region **1004.** Then, as shown in FIG. **3A****,** the resist **1009** is removed by ashing to thus leave a part of the hard mask **1008a** which is located above the p-type active region **1003.**

Next, as shown in FIG. **3B**, a p-type electrode formation film **1010,** for example, made of TaAlN and having a film thickness of 10 nm is deposited on the protection film **1007** and the hard mask **1008a.** As the material of the p-type electrode formation film **1010,** noble metal, such as Pt, Ir, and Ru, a material containing Al, Mo, or W, a material having a high work function (WF), such as TaCN, TaCNO, or the like may be used. The film thickness of the p-type electrode formation film **1010,** which can be changed appropriately according to the material thereof and the peripheral process, is preferably 5 nm or larger.

Subsequently, a hard mask **1008b** made of, for example, SiO₂ is formed on the p-type electrode formation film **1010,** and a part of the hard mask **1008b** which is located above the p-type active region **1003** is removed by photolithography, as shown in FIG. **3C****.** Then, the p-type electrode formation film **1010** is removed by dry etching or the like using the hard mask **1008b** remaining above the n-type active region **1004** as a mask, as shown in FIG. **3D****,** and the hard masks **1008a, 1008b** are removed with the use of hydrofluoric acid or the like, as shown in FIG. **3E****.** This exposes a part of the protection film **1007** which is located above the p-type active region **1003** and the p-type electrode formation film **1010** formed above the n-type active region **1004.**

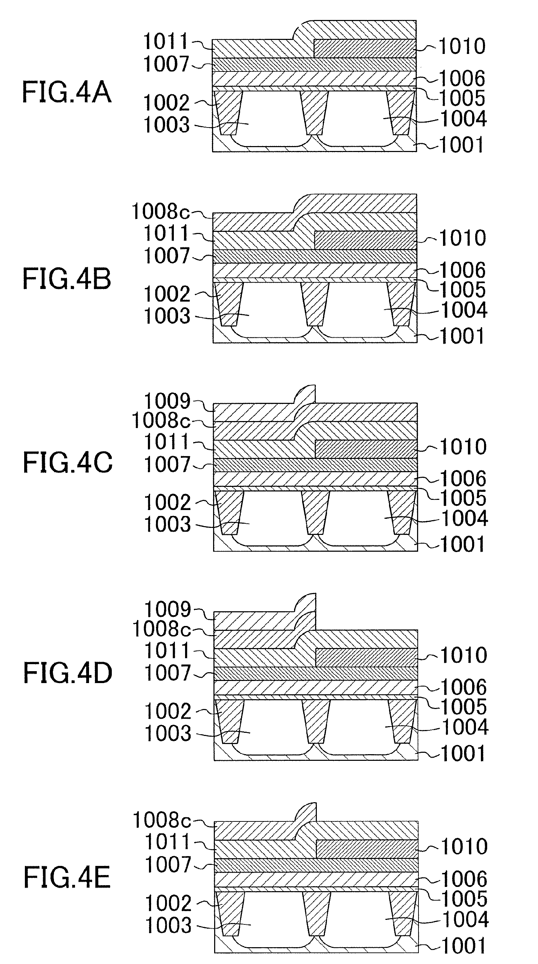

Thereafter, as shown in FIG. **4A****,** an n-type electrode formation film **1011,** for example, made of TaLaN or the like and having a thickness of 10 nm is deposited on the protection film **1007** and the p-type electrode formation film **1010.** The n-type electrode formation film **1011** may be made of a material containing a lanthanoide-based element selected from La, Ce, Pr, Nd, Pm, Sm, Eu, Gd, Tb, Dy, Ho, Er, Tm, Yb, and Ru, or a material having a low work function (WF), such as HfN, TaC, HfC, or the like. The film thickness of the n-type electrode formation film **1011,** which can be changed appropriately according to the material thereof and the peripheral process, is preferably 5 nm or larger.

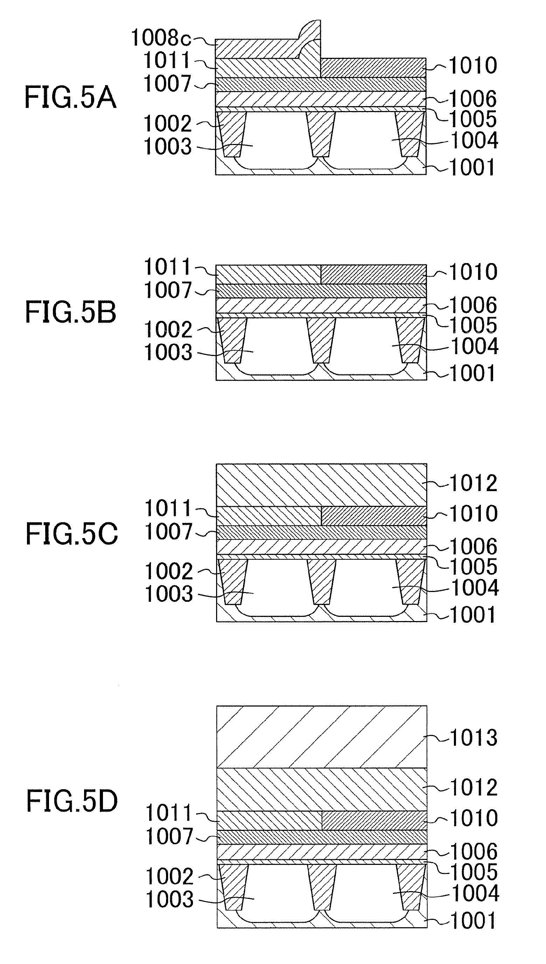

Next, as shown in FIG. **4B****,** a hard mask **1008c** is formed on the n-type electrode formation film **1011.** Then, a resist **1009** is formed on the hard mask **1008c,** and a part of the resist **1009** which is located above the n-type active region **1004** is removed by photolithography, as shown in FIG. **4C****,** a part of the hard mask **1008c** which is located above the n-type active region **1004** is removed with the use of the resist **1009** remaining above the p-type active region **1003** as a mask, as shown in FIG. **4D****,** and then, the remaining resist **1009** is removed by ashing, as shown in FIG. **4E****.** Then, a part of the n-type electrode formation film **1011** which is located above the n-type active region **1004** is removed by dry etching using the hard mask **1008c** remaining above the p-type active region **1003** as a mask, as shown in FIG. **5A****,** and the hard mask **1008c** is removed with the use of hydrofluoric acid or the like, as shown in FIG. **5B****.** It is noted that according to the material and/or the film thickness of the n-type electrode formation film **1011,** the following step as will be described later and shown in FIG. **5C** may be performed with a part of the n-type electrode formation film **1011** left on the p-type electrode formation film **1010** without performing the steps shown in FIG. **4B** to FIG. **4E****,** FIG. **5A,** and FIG. **5B****.**

Subsequently, as shown in FIG. **5C****,** the intermediate film **1012,** for example, made of TaN or the like and having a thickness of 5 nm is deposited on the p-type electrode formation film **1010** and the n-type electrode formation film **1011.** The material of the intermediate film **1012** is not limited to TaN and may be any other suitable material. In the semiconductor device manufacturing method in the present embodiment, the n-type electrode formation film **1011** is made of a La-base material, which is liable to be oxidized, and therefore, the intermediate film **1012** is formed as an anti-oxidation film. Wherein, the intermediate film **1012** may not be formed when the n-type electrode formation film **1011** is made of a material that is resistant to oxidation, such as TaC.

Thereafter, as shown in FIG. **5D****,** a third electrode formation film **1013,** for example, made of polysilicon and having a thickness of 100 nm is deposited on the intermediate film **1012.** Then, an impurity is implanted into the third electrode formation film **1013.**

Next, as shown in FIG. **6A****,** the underlying film **1005,** the gate insulating film **1006,** the protection film **1007,** the p-type electrode formation film **1010,** the n-type electrode formation film **1011,** the intermediate film **1012,** and the third electrode formation film **1013** are etched by photolithography and RIE (Reactive Ion Etching) so as to be left on respective predetermined regions of the p-type active region **1003** and the n-type active region **1004.**

Finally, as shown in FIG. **6B**, the extension regions **1020,** the sidewalls **1021,** the source/drain regions **1022** are formed, and an impurity is implanted into the source/drain region **1022** and is activated, to thus form the n-type MISFET and the p-type MISFET in the p-type active region **1003** and the n-type active region **1004,** respectively. If spike annealing at 1050 °C, for example, is performed for activating the impurity in the source/drain regions **1022,** the TaN-made protection film **1007** formed above the p-type active region **1003** reacts with the TaLaN-made n-type electrode formation film **1011** to diffuse the elements from the n-type electrode formation film **1011,** thereby forming the TaLaN-made first electrode formation film **1015.** While at the same time the TaN-made protection film **1007** formed above the n-type active region **1004** reacts with the TaAlN-made p-type electrode formation film **1010** to diffuse the elements from the p-type electrode formation film **1010,** thereby forming the TaAlN-made second electrode formation film **1014.** In order to cause the reactions, thermal treatment at 550 °C at the lowest is required. By the above reactions and diffusions, the protection film **1007** may be changed incompletely into the first electrode formation film **1015** or the second electrode formation film **1014** to remain partially on the gate insulating film **1006.** The remaining protection film **1007,** however, has an extremely small thickness, thereby involving no adverse influence on WF control as will be described later.

By the above described method, the n-type MISFET including the gate insulating film **1006,** the first gate electrode including the first electrode formation film **1015,** the intermediate film **1012,** and the third electrode formation film **1013,** the source/drain regions **1022,** and the extension regions **1020** is formed in the p-type active region **1003** while the p-type MISFET including the gate insulating film **1006,** the second gate electrode including the second electrode formation film **1014,** the intermediate film **1012,** and the third electrode formation film **1013,** the source/drain regions **1022,** and the extension regions **1020** is formed in the n-type active region **1004.**

In the semiconductor device manufacturing method of the present embodiment, TaN is used as the material of the protection film **1007,** and TaLaN is used as the material of the n-type electrode formation film **1011.** Accordingly, the first electrode formation film **1015** formed by thermal treatment is made of TaLaN though the concentration of La thereof is slightly lower than that of the n-type electrode formation film **1011,** so that the first electrode formation film **1015** included in the first gate electrode of the n-type MISFET contains La exhibiting a significant effect of lowering the WF. Hence, the threshold voltage (Vt) is lowered. The La concentration profile in the thickness direction of the first electrode formation film **1015** shows a tendency that the concentration of La decreases as it goes in the direction that the film thickness reduces. In other words, the concentration profiles of the elements (Ta and N), which compose also the protection film **1007,** in the thickness direction of the first electrode formation film **1015** show a tendency that the concentrations thereof increase as they go toward the semiconductor substrate **1001.**

Similarly, the use of TaAlN as the material of the p-type electrode formation film **1010** allows the second electrode formation film **1014** formed by thermal treatment to be made of TaAlN having a concentration of Al slightly lower than that of the p-type electrode formation film **1010.** Accordingly, the second electrode formation film **1014** included in the second gate electrode of the p-type MISFET contains Al having a significant effect of increasing the WF to exhibit low threshold voltage. The Al concentration profile in the thickness direction of the second electrode formation film **1014** shows a tendency that the concentration of Al decreases as it goes in the direction that the film thickness reduces. In other words, the concentration profile of the elements (Ta and N), which compose also the protection film **1007,** in the thickness direction of the second electrode formation film **1014** show a tendency that the concentrations thereof increase as they go toward the semiconductor substrate **1001.**

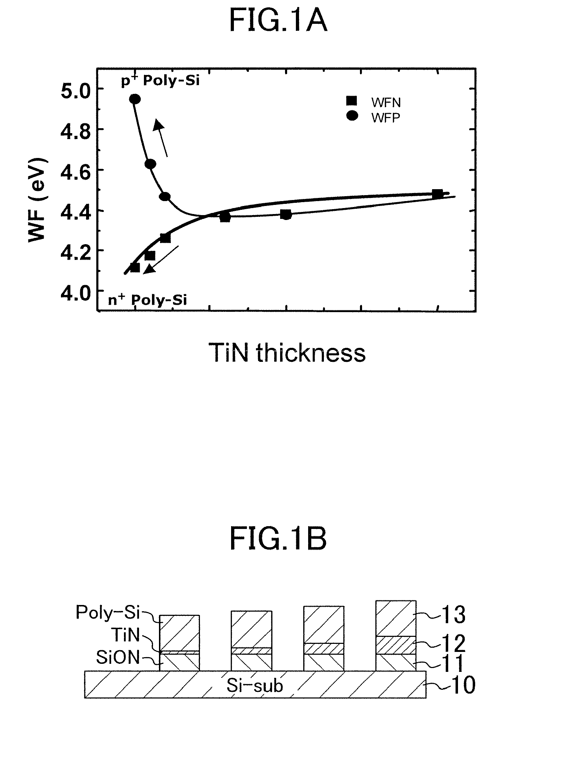

In the semiconductor device manufacturing method in accordance with the present invention, preferably, the thickness of the protection film **1007** before thermal treatment is smaller than each film thickness of the n-type electrode formation film **1011** and the p-type electrode formation film **1010.** This enables setting of the work functions of the first electrode formation film **1015** and the second electrode formation film **1014** formed by thermal treatment within predetermined ranges to enhance the effect of the WF control. The WF control will be described below in detail with reference to FIG. **1A** and FIG. **1B****.**

FIG. **1A** is a graph showing the relationship between the work functions in a semiconductor device including a TiN layer in accordance with the present invention and the film thickness of the TiN film. FIG. **1B** is a sectional view schematically showing the semiconductor device including the TiN layer in accordance with the present invention. The data of the work function (WF (eV)) indicated in FIG. **1A** are results obtained in such a manner that p-type MISFETs and n-type MISFETs are formed each of which has a layered structure in which a gate insulating film 11 made of SiON, a TiN layer **12,** and a polysilicon layer **13** are layered on a silicon substrate **10 in** this order from the bottom and the work function (WFP) of the p-type MISFET and the work function (WFN) of the n-type MISFET with respect to the thickness of the TiN layer **12** are evaluated.

As indicated in FIG. 1A, in a range where the film thickness of the TiN layer **12** is sufficiently small, the work function of the p-type MISFET (p⁺ Poly-Si in FIG. 1A) and the work function of the n-type MISFET (n⁺ Poly-Si in FIG. **1A****)** exhibit substantially the same behavior as that of polysilicon, and the work functions of the p-type MISFET and the n-type MISFET vary differently according to the kind of an impurity implanted in polysilicon. In contrast, as the film thickness of the TiN layer is increased, the work functions of the p-type MISFET and the n-type MISFET approximate to each other to be a work function that TiN has inherently. This phenomenon might occur because: when the TiN layer **12** is small in film thickness, reaction of TiN with the polysilicon layer **13** and the SiON-made gate insulating film **11** generates a substance having a large silicon ratio to Ti at the boundary portion therebetween so that the TiN layer **12** exhibits substantially the same property as polysilicon. The above phenomenon is observed in the cases where a TaN layer is used in place of the TiN layer **12** and where tungsten is used in place of polysilicon, and has been proved as a common phenomenon observed when metal of a thin film in contact with a material of a thick film is subjected to high-temperature treatment, rather than a phenomenon inherent to TiN.

As can be understood from the results indicated in FIG. **1A****,** in the semiconductor device manufacturing method of the present embodiment, high-temperature treatment for activating the source/drain regions or the like causes the protection film **1007** formed in each of the p-type MISFET and the n-type MISFET to react with the p-type electrode formation film **1010** and the n-type electrode formation film **1011** respectively formed in the p-type MISFET and the n-type MISFET, thereby diffusing the elements in the protection film **1007.** If the protection film **1007** has a sufficiently small film thickness while the p-type electrode formation film **1010** and the n-type electrode formation film **1011** have sufficiently large film thicknesses, the second electrode formation film **1014** formed by reaction of the protection film **1007** with the p-type electrode formation film **1010** has substantially the same compositions as the p-type electrode formation film **1010** while the first electrode formation film **1015** formed by reaction of the protection film **1007** with the n-type electrode formation film **1011** has substantially the same compositions as the n-type electrode formation film **1011.** Accordingly, when the p-type electrode formation film **1010** is made of noble metal, such as Pt, Ir, Ru, or the like, a material containing Al, Mo, or W, or a material having a high work function (WF) approximating to the work function (approximately 5.2 eV) at the top edge of the valance band of silicon, such as TaCN, TaCNO, or the like, the second electrode formation film **1014** has a sufficiently high work function. On the other hand, when the n-type electrode formation film **1011** is made of a material containing a lanthanoide-based element selected from La, Ce, Pr, Nd, Pm, Sm, Eu, Gd, Tb, Dy, Ho, Er, Tm, Yb, and Ru, or a material having a low work function (WF) approximating to the work function (approximately 4.1 eV) at the bottom edge of the conduction band of silicon, such as HfN, TaC, HfC, or the like, the first electrode formation film **1015** has a comparatively low work function. It is preferable that at least one of the first electrode formation film **1015** and the second electrode formation film **1014** is formed of an alloy film.

Even in the case where the protection film **1007** is made of, for example, the same material (having a high work function) as the p-type electrode formation film **1010,** the use of TaLaN having a higher concentration of La as the material of the n-type electrode formation film **1011** can sufficiently lower the work function of the first electrode formation film **1015** formed by thermal treatment. The thus formed first electrode formation film **1015** can be used for the gate electrode of the n-type MISFET.

In the semiconductor device of the present embodiment, the n-type electrode formation film **1011** preferably has a work function of 4.4 eV or lower. The more the work function thereof approximates to 4.1 eV, the more preferable it is because it approximates to the work function at the bottom edge of the conduction band of silicon. As well, the p-type electrode formation film **1011** preferably has a work function of 4.7 eV or higher. The more the work function thereof approximates to 5.2 eV, the more preferable it is because it approximates to the work function at the top edge of the valence band of silicon.

As described above, in the semiconductor device manufacturing method of the present embodiment, provision of the protection film **1007** on the gate insulating film **1006** prevents the gate insulting film **1006** from damage by etching and the like and prevents the film thickness of the gate insulating film **1006** from changing in forming the n-type electrode formation film **1011** and the p-type electrode formation film **1010.** Hence, the semiconductor device manufacturing method of the present embodiment attains a highly reliable semiconductor device including a gate insulating film excellent in quality even when miniaturized.

Further, in the step shown in FIG. 6A of the semiconductor device manufacturing method of the present embodiment, reaction of the protection film **1007** with the n-type electrode formation film **1011** and the p-type electrode formation film **1010** is caused by high-temperature treatment, so as to form the first electrode formation film **1015** and the second electrode formation film **1014** having different compositions from each other and exhibiting the respective predetermined work functions on the single semiconductor substrate **1001.** Accordingly, when metals having predetermined work functions are used as the materials of the n-type electrode formation film **1011** and the p-type electrode formation film **1010,** an n-type MISFET and a p-type MISFET including gate electrodes made of the metals can be formed separately on a single semiconductor substrate. The thus formed semiconductor device can perform high-speed operation with depletion of the gate electrodes suppressed even when miniaturized. In addition, when a high dielectric, such as HfSiON is used as the material of the gate insulating film **1006** as in the semiconductor device manufacturing method of the present embodiment, a semiconductor device having high current drivability is attained with leak current suppressed even when the gate insulating film is reduced in thickness.

### (Embodiment 2)

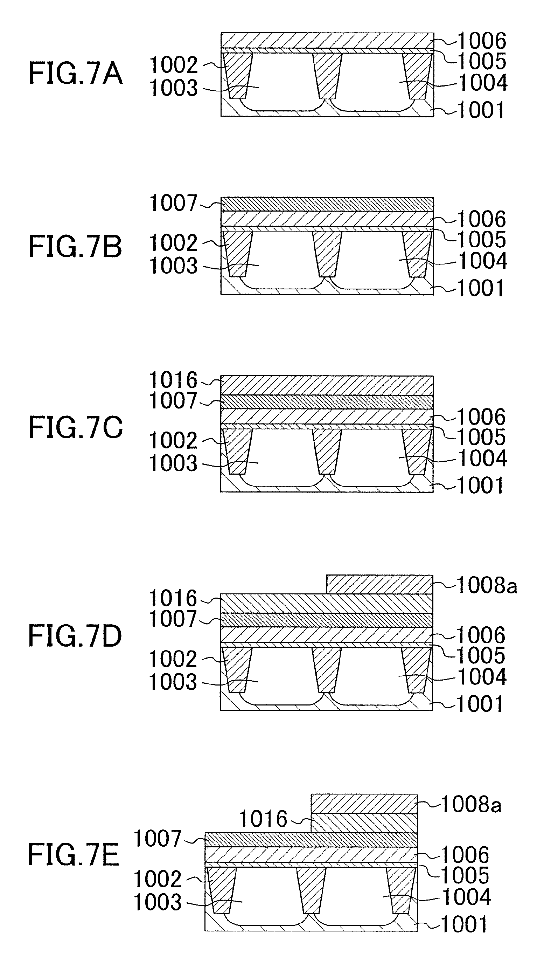

A semiconductor device manufacturing method in accordance with Embodiment 2 of the present invention will be described below with reference to the drawings. FIG. 7 to FIG. **10** are sectional views showing the semiconductor device manufacturing method in accordance with Embodiment 2 of the present invention. The semiconductor device manufacturing method of the present embodiment is a method for manufacturing the semiconductor device of Embodiment 1 by a process different from the method of Embodiment 1. Wherein, the same steps as in the semiconductor device manufacturing method of Embodiment 1 will be described in a simplified manner.

First, as shown in FIG. **7A****,** the p-type active region **1003,** the n-type active region **1004,** and the isolation layer **1002** for separating them are formed in the semiconductor substrate **1001,** and the underlying film **1005** made of, for example, SiO₂ and the gate insulating film **1006** formed of a HfSiO film or the like are formed sequentially on the semiconductor substrate **1001** likewise Embodiment 1. Then, as shown in FIG. **7B****,** the protection film **1007** made of TaN or the like is deposited on the gate insulating film **1006.**

Next, as shown in FIG. **7C****,** a p-type electrode formation film **1016,** for example, made of Al and having a thickness of 5 nm is deposited on the protection film **1007.** Other than Al, the material of the p-type electrode formation film **1016** may be noble metal, such as Pt, Ir, Ru, or the like, a material containing Mo or W, or a material having a high work function, such as TaCN, TaCNO, or the like. The film thickness of the p-type electrode formation film **1016,** which can be changed appropriately according to the material thereof and the peripheral process, is preferably 5 nm or larger. In the present embodiment, the p-type electrode formation film **1016** is formed of a sole Al film, but a film made of metal, such as TiN, TaN, or the like may be formed on the Al film to have a thickness of approximately 5 nm in total according to a condition, such as in the case where dry etching is performed with much oxygen in the step shown in FIG. **7E** as will be described later.

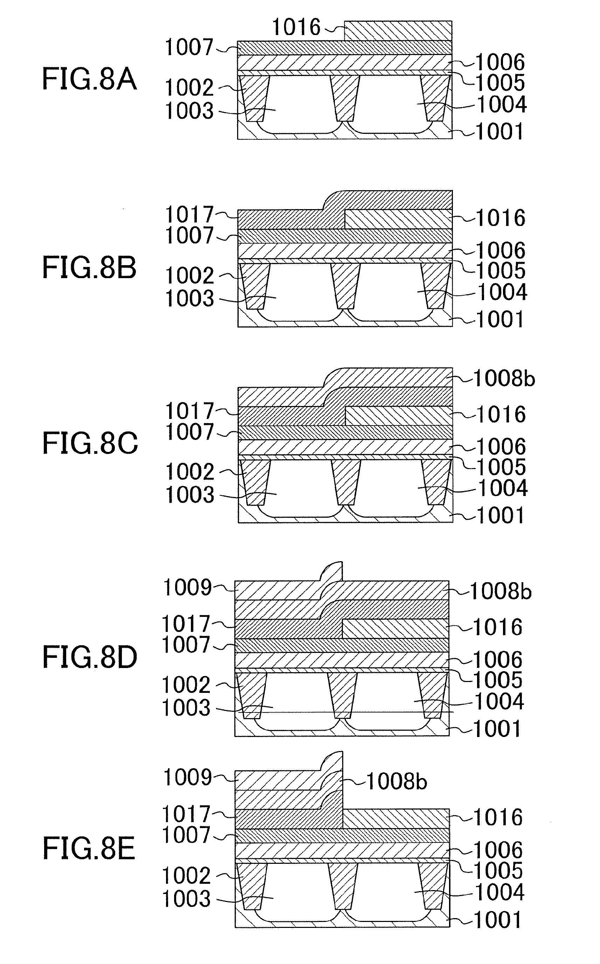

Subsequently, the hard mask **1008a** made of, for example, SiO₂ is formed on the p-type electrode formation film **1016,** and a part of the hard mask **1008a** which is located above the p-type active region **1003** is removed by photolithography, as shown in FIG. **7D****.** Then, the p-type electrode formation film **1016** is removed by dry etching using the hard mask **1008a** remaining above the n-type active region **1004** as a mask, as shown in FIG. **7E****,** and the hard mask **1008a** is removed with the use of hydrofluoric acid or the like, as shown in FIG. **8A****.** This exposes a part of the protection film **1007** which is located above the p-type active region **1003** and the p-type electrode formation film **1016** remaining above the n-type active region **1004.**

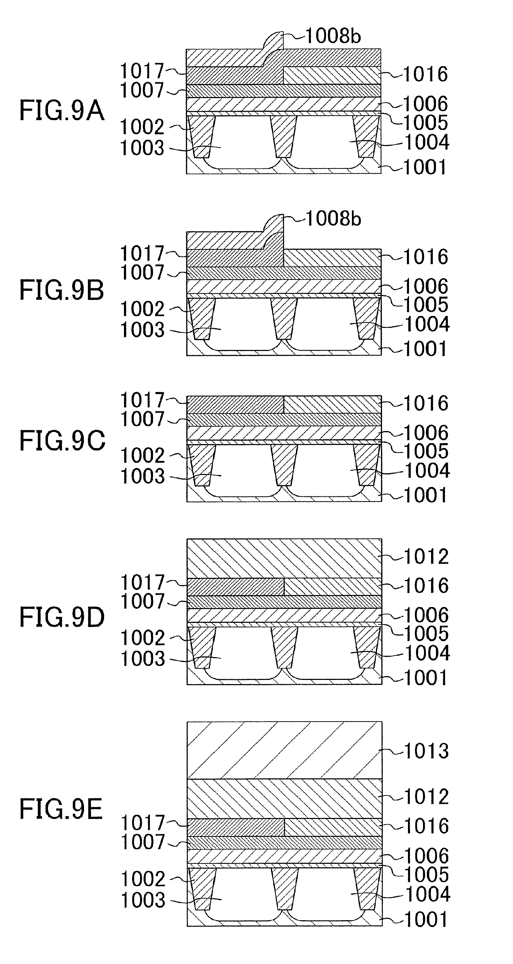

Thereafter, as shown in FIG. **8B**, an n-type electrode formation film **1017,** for example, made of La or the like and having a film thickness of 5 nm is deposited on the protection film **1007** and the p-type electrode formation film **1016.** Other than La, the material of the n-type electrode formation film **1017** may be a material containing a lanthanoid-based element selected from Ce, Pr, Nd, Pm, Sm, Eu, Gd, Tb, Dy , Ho, Er, Tm, Yb, and Ru, or a material having a low work function, such as HfN, TaC, HfC, or the like. The film thickness of the n-type electrode formation film **1017,** which can be changed appropriately according to the material thereof and the peripheral process, is preferably 5 nm or larger. In the present embodiment, the n-type electrode formation film **1017** is formed of a sole La film, but a film made of metal, such as TiN, TaN or the like may be formed on the La film to have a thickness of approximately 5 nm in total according to a condition, such as in the case where dry etching is performed with much oxygen in the step shown in FIG. **9B** as will be described later.

Next, as shown in FIG. **8C****,** the hard mask **1008b** is formed on the n-type electrode formation film **1017.** Then, the resist **1009** is formed on the hard mask **1008b,** and a part of the resist **1009** which is located above the n-type active region **1004** is removed by photolithography, as shown in FIG. **8D****.** As shown in FIG. **8E****,** a part of the hard mask **1008b** which is located above the n-type active region **1004** is removed with the use of the resist **1009** remaining above the p-type active region **1003** as a mask. Then, the remaining resist **1009** is removed by ashing, as shown in FIG. **9A****,** a part of the n-type electrode formation film **1017** which is located above the n-type active region **1004** is removed by dry etching using the hard mask **1008b** remaining above the p-type active region **1003** as a mask, as shown in FIG. **9B****,** and then, the hard mask **1008b** is removed with the use of hydrofluoric acid or the like, as shown in FIG. **9C****.** It is noted that the following step shown in FIG. **9D** may be performed with a part of the n-type electrode formation film **1017** left on the p-type electrode formation film **1016** without performing the steps shown in FIG. **8C** to FIG. **8E** and FIG. **9A** to FIG. **9C** according to the material and/or the film thickness of the n-type electrode formation film **1017.**

Subsequently, as shown in FIG. **9D****,** the intermediate film **1012,** for example, made of TaN or the like and having a thickness of 5 nm is deposited on the p-type electrode formation film **1016** and the n-type electrode formation film **1017.** Then, as shown in FIG. **9E****,** the third electrode formation film **1013,** for example, made of polysilicon and having a thickness of 100 nm is deposited on the intermediate film **1012,** and then, an impurity is implanted into the third electrode formation film **1013.**

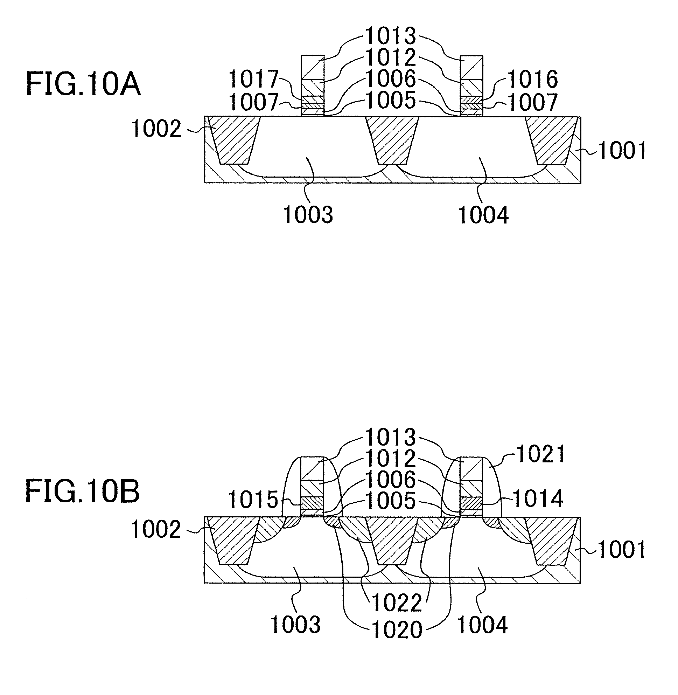

Thereafter, as shown in FIG. **10A****,** the underlying film **1005,** the gate insulating film **1006,** the protection film **1007,** the p-type electrode formation film **1016,** the n-type electrode formation film **1017,** the intermediate film **1012,** and the third electrode formation film **1013** are etched by photolithography and RIE so as to be left in respective predetermined regions of the p-type active region **1003** and the n-type active region **1004.**

Finally, as shown in FIG. **10B****,** the extension regions **1020,** the sidewalls **1021,** the source/drain regions **1022** are formed, and an impurity is implanted into the source/drain region **1022** and is activated, to thus form the n-type MISFET and the p-type MISFET in the p-type active region **1003** and the n-type active region **1004,** respectively. If spike annealing at 1050 °C, for example, is performed for activating the impurity in the source/drain regions **1022,** the TaN-made protection film **1007** formed above the p-type active region **1003** reacts with the La-made n-type electrode formation film **1017** to diffuse the elements from the n-type electrode formation film **1017,** thereby forming the TaLaN-made first electrode formation film **1015.** On the other hand, the TaN-made protection film **1007** formed above the n-type active region **1014** reacts with the Al-made p-type electrode formation film **1016** to diffuse the elements from the p-type electrode formation film **1016,** thereby forming the second electrode formation film **1014** made of TaAlN. In order to cause the reactions, thermal treatment at 550 °C at the lowest is required. By the above reactions and diffusions, the protection film **1007** may be changed incompletely into the first electrode formation film **1015** or the second electrode formation film **1014** to remain partially on the gate insulating film **1006.** The remaining protection film **1007,** however, has an extremely small thickness, thereby involving no adverse influence on the WF control.

Thus, the n-type MISFET including the gate insulating film **1006,** the first gate electrode including the first electrode formation film **1015,** the intermediate film **1012,** and the third electrode formation film **1013,** the source/drain regions **1022,** and the extension regions **1020** is formed in the p-type active region **1003** while the p-type MISFET including the gate insulating film **1006,** the second gate electrode including the second electrode formation film **1014,** the intermediate film **1012,** and the third electrode formation film **1013,** the source/drain regions **1022,** and the extension regions **1020** is formed in the n-type active region **1004.** The above described method attains the aforementioned semiconductor device of Embodiment 1.

In the semiconductor device manufacturing method of the present embodiment, TaN is used as the material of the protection film **1007** while La is used as the material of the n-type electrode formation film **1017,** and accordingly, the first electrode formation film **1015** formed by thermal treatment is made of TaLaN. As a result, the first electrode formation film **1015** included in the first gate electrode of the n-type MISFET contains La exhibiting a significant effect of lowering the WF. Hence, the threshold voltage (Vt) is lowered. The La concentration profile in the thickness direction of the first electrode formation film **1015** shows a tendency that the concentration of La decreases as it goes in the direction that the film thickness reduces. In other words, in the concentration profiles of the elements (Ta and N), which compose also the protection film **1007,** in the thickness direction of the first electrode formation film **1015** show a tendency that the concentrations thereof increase as they go toward the semiconductor substrate **1001.**

Similarly, the use of Al as the material of the p-type electrode formation film **1016** allows the second electrode formation film **1014** formed by thermal treatment to be made of TaAlN. Accordingly, the second electrode formation film **1014** included in the gate electrode of the p-type MOSFET contains Al having a significant effect of increasing the WF to exhibit low threshold voltage. The Al concentration profile in the thickness direction of the second electrode formation film **1014** shows a tendency that the concentration of Al decreases as it goes in the direction that the film thickness reduces. In other words, the concentration profiles of the elements (Ta and N), which compose also the protection film **1007,** in the thickness direction of the second electrode formation film **1014** show a tendency that the concentrations thereof increase as they go toward the semiconductor substrate **1001.** Preferably, at least one of the first electrode formation film **1015** and the second electrode formation film **1014** is an alloy film.

As described above, in the semiconductor device manufacturing method of the present embodiment, similarly to the method of Embodiment 1, the protection film **1007** protects the gate insulating film **1006** to prevent disadvantages to the gate insulating film **1006,** such as damage by etching and the like in forming the n-type electrode formation film **1017** and the p-type electrode formation film **1016.** In comparison with the semiconductor device manufacturing method of Embodiment 1, the method of Embodiment 2 is small in the number of the hard masks **(1008a, 1008b)** and the like and can attain the same semiconductor device as in Embodiment 1 by the steps of which number is smaller than that in the Embodiment 1. Accordingly, employment of the semiconductor device manufacturing method of the present embodiment attains comparatively easily a highly reliable semiconductor including a gate insulating film excellent in quality even when miniaturized. Further, when metals having predetermined work functions are used as the materials of the n-type electrode formation film **1017** and the p-type electrode formation film **1016,** an n-type MISFET and a p-type MISFET can be formed separately in a single semiconductor substrate. Thus, a semiconductor device is attained which includes an n-type MISFET and a p-type MISFET having high current drivability with depletion of the gate electrodes suppressed even when miniaturized.

In the methods of Embodiments 1 and 2, polysilicon in which an impurity is implanted is used as the material of the third electrode formation film **1013,** but the impurity may not be necessarily implanted. The material of the third electrode formation film **1013** formed in the n-type MISFET may be a material different from that of the third electrode formation film **1013** formed in the p-type MISFET. In the case where metal such as tungsten, metal silicide (titanium silicide, cobalt silicide, or nickel silicide) or the like is used as the material of the third electrode formation film **1013,** the manufactured semiconductor can operate at further higher speed.

Further, in the methods of Embodiment 1 and 2, the semiconductor device includes the p-type active region **1003** and the n-type active region **1004** formed in the single semiconductor substrate **1001,** but the present invention is not limited thereto and is applicable to a semiconductor device including a first MISFET and a second MISFET respectively including gate electrodes made of different materials.

In addition, a silicon substrate is used as the semiconductor substrate **1001** in the methods of Embodiments 1 and 2, but the present invention is not limited thereto and a substrate made of another material may be used. For example, a SOI (Semiconductor Oxide Insulator) substrate or a substrate made of mixed crystal, such as a GaAs substrate, an InP substrate, or the like may be used.

As described above, the semiconductor device and the manufacturing methods thereof in accordance with the present invention are useful for enhancing the drivability of miniaturized CMISs and the like.

## Claims

1. A semiconductor device comprising:
a semiconductor substrate;
first and second regions formed in the semiconductor substrate;
a first MISFET including a first gate insulating film which is formed on the first region and a first gate electrode which is formed on the first gate insulating film and includes a first electrode formation film of which upper part and other part each include a first metallic element or a first conductivity type compound, a concentration of the first metallic element or the first conductivity type compound of the upper part being larger than a concentration of the first metallic element or the first conductivity type compound of the other part; and
a second MISFET including a second gate insulating film which is formed on the second region and a second gate electrode which is formed on the second gate insulating film and includes a second electrode formation film of which upper part and other part each include a second metallic element or a second conductivity type compound, a concentration of the second metallic element or the second conductivity type compound of the upper part being larger than a concentration of the second metallic element or the second conductivity type compound of the other part.

2. The semiconductor device of Claim 1,
wherein the first region is a p-type active region while the second region is an n-type active region.

3. The semiconductor device of Claim 2
wherein the first metallic element has a work function smaller than the second metallic element.

4. The semiconductor device of Claim 2 or 3,
wherein the first electrode formation film contains at least one of HfN, HfC, TaC, and a material including a lanthanoide-based element.

5. The semiconductor device of any one of Claims 2 to 4,
wherein the second electrode formation film contains at least one of TaCN, TaCNO, and a material containing at least one of noble metal, Al, Mo, and W.

6. The semiconductor device of any one of Claims 1 to 5, further comprising:
a first protection film formed between the first gate insulating film and the first electrode formation film; and
a second protection film formed between the second gate insulating film and the second electrode formation film.

7. The semiconductor device of Claim 6,
wherein the first protection film and the second protection film contain at least Ta or Ti.

8. The semiconductor device of any one of Claims 1 to 7,
wherein the first gate insulating film and the second gate insulating film are formed of the same material.

9. The semiconductor device of Claim 8,
wherein the first gate insulting film and the second gate insulating film are formed of a high dielectric constant material.

10. The semiconductor device of any one of Claims 1 to 9,
wherein the first gate electrode further includes a third electrode formation film formed on or above the first electrode formation film, and
the second gate electrode further includes a fourth electrode formation film formed on or above the second electrode formation film.

11. The semiconductor device of Claim 10,
wherein at least one of the third electrode formation film and the fourth electrode formation film contains metal.

12. The semiconductor device of Claim 10 or 11,
wherein the first gate electrode further includes a first intermediate film formed between the first electrode formation film and the third electrode formation film, and
the second gate electrode further includes a second intermediate film formed between the second electrode formation film and the fourth electrode formation film.

13. A method for manufacturing a semiconductor device including a semiconductor substrate, first and second regions, a first MISFET including a first gate insulating film and a first gate electrode, and a second MISFET including a second gate insulating film and a second gate electrode, the method comprising the steps of:
(a) after formation of the first region and the second region in the semiconductor substrate, forming the first gate insulating film on the first region and forming the second gate insulating film on the second region;
(b) forming a protection film on the first gate insulating film and the second gate insulating film;
(c) forming a first electrode formation film on a part of the protection film which is formed on the first gate insulating film;
(d) forming a second electrode formation film on a part of the protection film which is formed on the second gate insulating film; and
(e) heating the semiconductor substrate to cause a reaction of the protection film to the first electrode formation film for forming the first gate electrode that includes a third electrode formation film and to cause a reaction of the protection film to the second electrode formation film for forming the second gate electrode that includes a fourth electrode formation film.

14. The semiconductor device manufacturing method of Claim 13,
wherein in the step (c), the protection film has a thickness smaller than the first electrode formation film, and
in the step (d), the protection film has a thickness smaller than the second electrode formation film.

15. The semiconductor device manufacturing method of Claim 13 or 14,
wherein the first region is a p-type active region while the second region is an n-type active region.

16. The semiconductor device manufacturing method of Claim 15,
wherein the first electrode formation film contains at least one of HfN, HfC, TaC, and a material including a lanthanoide-based element.

17. The semiconductor device manufacturing method of Claim 15 or 16,
wherein the second electrode formation film contains at least one of TaCN, TaCNO, and a material containing at least one of noble metal, Al, Mo, and W.

18. The semiconductor device manufacturing method of any one of Claims 13 to 17,
wherein the protection film contains at least Ta or Ti.

19. The semiconductor device manufacturing method of any one of Claims 13 to 18,
wherein in the step (e), the first gate electrode is formed so as to include the third electrode formation film and a residual part of the protection film which results from the reaction to the first electrode formation film while the second gate electrode is formed so as to include the fourth electrode formation film and a residual part of the protection film which results from the reaction to the second electrode formation film.

20. The semiconductor device manufacturing method of any one of Claims 13 to 19,
wherein the first gate insulating film and the second gate insulating film are formed of the same material, and
in the step (a), the first gate insulating film and the second gate insulating film are formed simultaneously.

21. The semiconductor device manufacturing method of Claim 20,
wherein the first gate insulting film and the second gate insulating film are formed of a high dielectric constant material.

22. The semiconductor device manufacturing method of any one of Claims 13 to 21, further comprising the step of:
(f) forming a fifth electrode formation film on or above the first electrode formation film and forming a sixth electrode formation film on or above the second electrode formation film,
wherein in the step (e), the first gate electrode further includes the fifth electrode formation film while the second gate electrode further includes the sixth electrode formation film.

23. The semiconductor device manufacturing method of Claim 22,
wherein at least one of the fifth electrode formation film and the sixth electrode formation film contains metal.

24. The semiconductor device manufacturing method of Claim 22 or 23,
wherein in the step (f), a first intermediate film is formed in addition between the first electrode formation film and the fifth electrode formation film while a second intermediate film is formed in addition between the second electrode formation film and the sixth electrode formation film, and
in the step (e), the first gate electrode further includes the first intermediate film while the second gate electrode further includes the second intermediate film.
